# Europäisches Patentamt

**European Patent Office**

**Office européen des brevets**

(11) Publication number: **0 032 958**
**B1**

---

(12) **EUROPEAN PATENT SPECIFICATION**

(45) Date of publication of patent specification: **03.04.85**

(21) Application number: **80901421.0**

(22) Date of filing: **30.07.80**

(86) International application number:
**PCT/JP80/00176**

(87) International publication number:
**WO 81/00490 19.02.81 Gazette 81/05**

(51) Int. Cl.⁴: **H 01 L 29/78, G 11 C 11/40, H 01 L 27/10**

---

(54) **SEMICONDUCTOR MEMORY DEVICE.**

---

(30) Priority: **31.07.79 JP 98199/79**

(43) Date of publication of application:
**05.08.81 Bulletin 81/31**

(45) Publication of the grant of the patent:
**03.04.85 Bulletin 85/14**

(84) Designated Contracting States:
**DE FR GB NL**

(56) References cited:
**DE-A-2 129 181**
**JP-A-53 059 381**
**US-A-4 004 159**

**IEEE TRANSACTIONS ON ELECTRON DEVICES, vol. ED-24, no. 5, May 1977, NEW YORK (US), A. SCHEIBE et al.: "Technology of a new n-channel one-transistor EAROM cell calles SIMOS", pages 600-606**

(73) Proprietor: **FUJITSU LIMITED**
**1015, Kamikodanaka Nakahara-ku Kawasaki-shi Kanagawa 211 (JP)**

(72) Inventor: **ITO, Takashi**
**408, Noborito Tama-ku Kawasaki-shi Kanagawa 214 (JP)**
Inventor: **HIJIYA, Shinpei**
**8-11, Misono 3-chome, Sagamihara-shi Kanagawa 202 (JP)**

(74) Representative: **Rackham, Stephen Neil et al GILL JENNINGS & EVERY 53-64 Chancery Lane London WC2A 1HN (GB)**

---

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

Technical field

The present invention relates to a non-volatile semiconductor memory according to the first part of Claim 1.

Background art

Most of conventional semiconductor memories are so-called volatile memories of the type where the information stored disappears when the power supply is cut off. As means for eliminating this disadvantage of volatile memories, there are known a so-called MNOS cell type memory having a structure comprising a metal layer, a silicon nitride layer, a silicon oxide layer and a silicon layer, and a so-called FAMOS cell type memory in which a floating gate having an electron-sequestering capacity is formed in a gate insulating oxide layer. These memories are inclusively called "non-volatile memories".

A non-volatile semiconductor memory having all the features mentioned in the pre-characterising part of Claim 1 is known for instance from DE—A—2 129 181.

The above mentioned non-volatile memories are important and indispensable for many electronic devices and systems. However, these non-volatile memories are still insufficient in such characteristics as writing voltage and rewriting voltage characteristics. For example, voltages of about 15 and about 35 volts are necessary for writing and rewriting of information. Furthermore, more than 1 milisecond is necessary as the writing time and writing time is longer by more than several orders than in random access volatile semiconductor memories. Therefore, the application filed of conventional non-volatile memories is limited.

Disclosure of invention

It is, therefore, a primary object of the present invention to make writing and rewriting possible with a single polarity power source by making simple improvements on a non-volatile memory and to provide an improved non-volatile memory device in which both the writing voltage and the rewriting voltage can be remarkably reduced, and rewriting can be performed at a high speed.

In accordance with the present invention, there is provided a non-volatile semiconductor memory comprising a semiconductor substrate and, formed thereon, a source region, a drain region, a floating gate insulating oxide layer, a floating gate and a control gate coupled to said floating gate, wherein the electric field for injecting hot carriers into the floating gate is at least as large as the avalanche breakdown initiating voltage in the substrate, which memory is characterised in that the structure parameter of the non-volatile memory is set as a value satisfying the requirement:

$$\frac{C_{FD}+C_2}{C_1+C_2+C_{FS}+C_{FD}} \geqq a \geqq \frac{C_{FD}}{C_1+C_2+C_{FS}+C_{FD}}$$

$$a = \frac{d_1|E_B|-0.16|V_D|}{|V_D|}$$

wherein $C_1$ stands for the capacity between the semiconductor substrate and the floating gate, $C_2$ stands for the capacity between the floating gate and the control gate, $C_{FS}$ stands for the capacity between the source region and the floating gate, $C_{FD}$ stands for the capacity between the drain region and the floating gate, $d_1$ stands for the thickness of at least a part of the floating gate insulating layer, $E_B$ stands for the avalanche breakdown initiating voltage between the drain region and the semiconductor substrate, and $V_D$ stands for the voltage applied to the drain.

By the way, above mentioned memory is a n-channel device, both $E_B$ and $V_D$ have positive values, while said memory is a p-channel device, both $E_B$ and $V_D$ have negative values.

Brief description of drawings

Figure 1 is a sectional view illustrating the main parts of one embodiment of the semiconductor memory according to the present invention.

Figure 2 is a diagram illustrating an equivalent circuit of the memory illustrated in Figure 1.

Figure 3 is a graph that is used for determining the structure parameter of the memory illustrated in Figure 1.

Best mode for carrying out the invention

A preferred embodiment of the present invention is illustrated below in conjunction with the accompanying drawings.

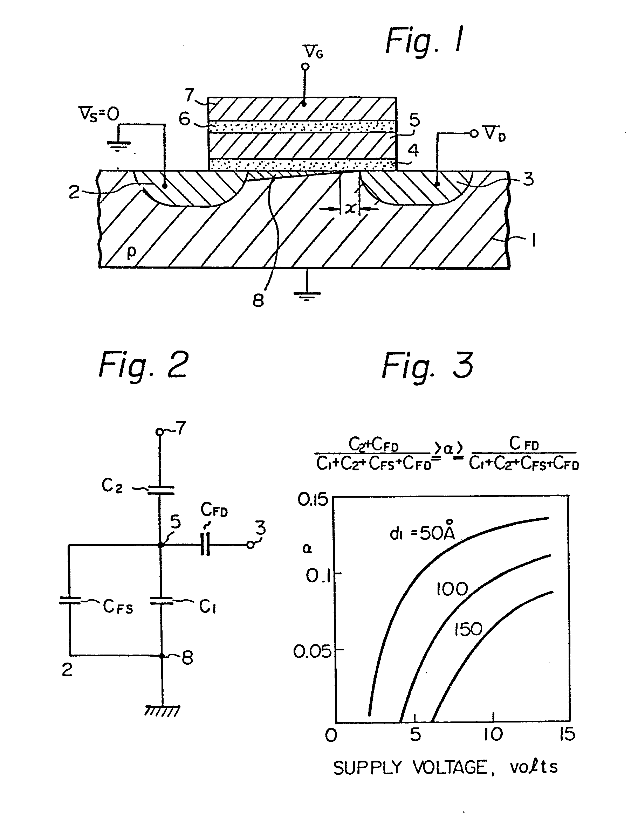

Figure 1 is a sectional view illustrating the main parts of one embodiment of the semiconductor memory device according to the present invention. This semiconductor memory device has a structure similar to the structure of a floating gate type MOS filed effect transistor. Incidentally, the N-type channel structure is illustrated in the accompanying drawings.

**0 032 958**

The drawings represent a P-type silicon semiconductor substrate 1, an $N^+$-type source region 2, an $N^+$-type drain region 3, a floating gate insulating layer 4, a floating gate, a control gate insulating layer 6, a control gate 7 and a region 8 where a conductive channel is to be formed. In the present embodiment, the gates 5 and 7 may be formed of a semiconductor such as an impurity-doped polycrystalline silicon semiconductor or a metal.

In the present embodiment, a conductive channel is formed in the region 8 by the influence of charges accumulated in the floating gate 5 or by the voltage applied to the control gate 7. When this channel is formed, the voltage applied to the control gate 7 is higher than the threshold voltage Vth. The memory detects the height of this threshold voltage Vth.

In order to inject charges into the floating gate 5, a so-called avalanche breakdown is caused in the junction between the substrate 1 and the drain region 3, and formed hot electrons or holes are injected into the floating gate 4 through the insulating layer 4. The speed of this injection determines the operation speed of the memory and the necessary power source. Since it is the electric field applied to the insulation layer 4 that determines this injection speed, how effectively this electric field should be applied to the insulating layer 4 is important.

Supposing that both the substrate 1 and the source region 2 are grounded, then the equivalent circuit formed is as illustrated in Figure 2. If charges of $\Delta Q$ are accumulated in the floating gate 5 and voltages $V_G$ and $V_D$ are applied to the control gate 7 and drain region 3, respectively, the electric field Ex generated on the insulating layer 4 at the point separated by the distance x from the junction between the substrate 1 and the drain region 3 is expressed by the following formula [Takashi Ito et al: Low-Voltage Alternable EAROM Cells with Nitride-Barrier Avalanche-Injection MIS(NAMIS), IEEE Transaction on Electron Device, Vol. ED-26, No. 6, June 1979, pages 906—913].

$$E_x = \frac{\Delta Q + C_2 V_G + C_{FD} V_D - (C_1 + C_2 + C_{FS} + C_{FD})(\sqrt{V_D} - \sqrt{qNA/2\varepsilon s} \cdot x)^2}{d_1(C_1 + C_2 + C_{FB} + C_{FD})} \tag{1}$$

wherein $C_1$ stands for the capacity between the substrate 1 and the floating gate 5, $C_2$ stands for the capacity between the floating gate 5 and the control gate 7, $C_{FS}$ stands for the capacity between the source region 2 and the floating gate 5, $C_{FD}$ stands for the capacity between the drain region 3 and the floating gate 5, $d_1$ stands for the thickness of the floating gate insulating layer 4 in the injection region where hot carriers are injected into the floating gate 5 from the substrate 1 (at the point of the above-mentioned distance x), q indicates the electron charge, NA represents the impurity concentration in the region 8 (the acceptor concentration in the case of the P-type), and $\varepsilon s$ designates the dielectric constant of the substrate 1.

The structure of the memory device of the present invention is not limited to the basic structure illustrated in Figure 1, but any of the structures represented by the equivalent circuit of Figure 2 can be used.

In order to inject hot carriers into the floating gate 5, the electric field Ex should be at least as large as the avalance breakdown initiating electric field $E_B$ in the substrate. That is the following requirement should be satisfied.

$$|Ex| \geq E_B \tag{2}$$

In the above-mentioned device, in connection with hot carriers generated in the $N^+$-P junction between the drain region 3 and the substrate 1, in order to inject electrons into the floating gate 5, the voltage Vg applied to the control gate 7 should satisfy the requirement of Vg>0, and in order to inject holes into the floating gate 5, the voltage $V_G$ should satisfy the requirement of $V_G \approx 0$. Accordingly, single polarity power source operation is realized and, therefore, a memory which is very easy to use can be provided. Although conditions that should be satisfied for injection of electrons and holes by the single polarity operation can be obtained from the formulae (1) and (2), x is an unknown number. We, however, succeeded in obtaining the value of x experimentally in the following manner. It was found that the ratio of the width of the drain depletion layer at the start of the avalanche breakdown to x is constant and 1/0.6. The following relation can be obtained from the formulae (1) and (2) by using this found relation as follows.

$$\frac{C_{FD} + C_2}{C_1 + C_2 + C_{FB} + C_{FD}} \geq a \geq \frac{C_{FD}}{C_1 + C_2 + C_{FS} + C_{FD}} \tag{3}$$

$$a = \frac{d_1 \cdot |E_B| - 0.16|V_D|}{|V_D|} \tag{4}$$

where both $E_B$ and $V_D$ have positive values in case of that the memory is an n-channel device while both $E_B$ and $V_D$ have negative values in case of that the memory is a p-channel device. Therefore, the intended

3

memory can be constructed if the structure parameter is determined so that the requirement defined by the formulae (3) and (4) is satisfied.

Figure 3 is a graph in which the values of the single electrode voltage applied to the memory cell plotted on the abscissa and the values of $\alpha$ in the formula (4) are plotted on the ordinate, with the thickness $d_1$ of the gate insulating oxide layer being as the parameter.

The memory device of the present invention will now be described with reference to a specific example.

The lower the voltage applied to the memory cell, the more facilitated is the handling of the cell. In this example, a single power source of 12 volts is used.

Since a voltage of about 10 volts can be applied to the memory cell, $V_D$ is set as $V_D = 10$ volts, and in this case, if calculation is carried out based on the assumption that NA is $1 \times 10^{17} cm^{-3}$, $E_B$ is $6.5 \times 10^5$ volt/cm and $d_1$ is 10 nm, it is seen that $\alpha$ is equal to 0.095. The structure illustrated in Figure 1 is adopted. If the floating gate insulating layer 4 is a silicon nitride layer having a thickness of 10 nm, the dielectric constant of this layer 4 is 6. If the control gate insulating layer 6 is a silicon oxide layer having a thickness of 70 nm, the dielectric constant of this layer 6 is about 4. Supposing that the distance between the source region 2 and the drain region 3 is 5 μm and the channel width is 10 μm, and that each of the superposition thickness of the drain region 3 and the floating gate 5 and the superposition thickness of the source region 2 and the floating gate 5 is 0.3 μm, $C_1$ is $2.34 \times 10^{-13}F$, $C_2$ is $2.53 \times 10^{-14}$ and the sum of $C_{FD}$ and $C_{FS}$ is equal to $1.60 \times 10^{-14}F$. Accordingly, the following relations are obtained, and it is seen that the requirement of the formula (3) is satisfied.

$$\frac{C_{FD}}{C_1+C_2+C_{FS}+C_{FD}}=0.06 \text{ and } \frac{C_{FD}+C_2}{C_1+C_2+C_{FS}+C_{FD}}=0.14$$

If voltage pulses of 10 volts and 1 millisecond are applied to the drain region 3 and control gate 7 of the so constructed memory cell, electron generated by the avalanche breakdown caused at the junctions of the drain region 3 can be injected into the floating gate 4. Furthermore, if the control gate 7 is grounded and voltage pulses of 10 volts and 1 millisecond are applied to the drain 3, contrary to the above-mentioned case, holes can be injected into the floating gate 4.

As will be apparent from the foregoing illustration, according to the present invention, by determining the structure parameter so as to satisfy the requirement defined by the above-mentioned formulae in an MIS electric field effect semiconductor device comprising a floating gate and a control gate, writing can be accomplished by injecting electrons or holes into the floating gate at a low voltage for a short time. Furthermore, since writing is performed by injection of carriers produced by the avalance breakdown, the thickness of the insulating layer surrounding the floating gate can be relatively increased, and therefore, the stored information retention characteristic can be greatly improved.

**Claim**

A non-volatile semiconductor memory comprising a semiconductor substrate (1) and, formed thereon, a source region (2), a drain region (3), a floating gate insulating layer (4), a floating gate (5) and a control gate (7) capacity-coupled to said floating gate, wherein the electric field for injecting hot carriers into the floating gate is at least as large as the avalanche breakdown initiating electric field in the substrate, which memory is characterised in that the structure parameter of said memory is set as a value satisfying the requirement:

$$\frac{C_{FD}+C_2}{C_1+C_2+C_{FS}+C_{FD}} \geqq \alpha \geqq \frac{C_{FD}}{C_1+C_2+C_{FS}+C_{FD}}$$

$$\alpha = \frac{d_1|E_B|-0.16|V_D|}{|V_D|}$$

wherein $C_1$ stands for the capacity between the semiconductor substrate and the floating gate, $C_2$ stands for the capacity between the floating gate and the control gate, $C_{FS}$ stands for the capacity between the source region and the floating gate, $C_{FD}$ stands for the capacity between the drain region and the floating gate, $d_1$ stands for the thickness of at least a part of the floating gate insulating layer (4), $E_B$ stands for the avalanche breakdown initiating voltage between the drain region and the semiconductor substrate, and $V_D$ stands for the voltage applied to the drain.

**Patentansprüche**

1. Nichtflüchtiger Halbleiterspeicher mit einem Halbleitersubstrat (1) und, auf diesem gebildet, einem Sourcebereich (2), einem Drainbereich (3), einer die schwimmende Elektrode isolierenden Schicht (4), einer schwimmenden Gate (5) und einer Steuerelektrode (7), welche mit der schwimmenden Gate kapazitivgekoppelt ist, bei welcher das elektrische Feld zum Injizieren hießer Träger in die schwimmende Elektrode wenigstens so groß wie die einen Lawinendurchbruch in dem Substrat auslösende elektrische Feldstärke ist, dadurch gekennzeichnet, daß der Strukturparameter des genannten Speichers auf einen Wert eingestellt ist, der die Bedingung erfüllt:

$$\frac{C_{FD}+C_2}{C_1+C_2+C_{FS}+C_{FD}} \geqq \alpha \geqq \frac{C_{FD}}{C_1+C_2+C_{FS}+C_{FD}}$$

$$\alpha = \frac{d_1|E_B|-0.16|V_D|}{|V_D|}$$

wobei $C_1$ für die Kapazität zwischen dem Halbleitersubstrat und dem schwimmenden Gate. $C_2$ für die Kapazität zwischen der schwimmenden Gate und der Steuerelektrode, $C_{FS}$ für die Kapazität zwischen dem Sourcebereich und der schwimmenden Gate $C_{FD}$ für die Kapazität zwischen dem Drainbereich und der schwimmenden Gate, $d_1$ für die Dicke von wenigstens einem Teil der die schwimmende Gate isolierenden Schicht (4), $E_B$ für die den Lawinendurchbruch auslösende Spannung zwischen Drainbereich und Halbleitersubstrat und $V_D$ für die der Drain zugeführten Spannung stehen.

### Revendication

Mémoire à semiconducteurs permanente comprenant un substrat semiconducteur (1) et, sur celui-ci, une région de source (2), une région de drain (3), une couche (4) d'isolation de grille flottante, une grille flottante (5) et un grille de commande (7) couplée par capacité à ladite grille flottante, où le champ électrique permettant d'injecter des porteurs chauds dans la grille flottante est au moins aussi grand que le champ électrique pouvant déclencher la rupture par avalanche dans le substrat; laquelle mémoire est caractérisée en ce que le paramètre de structure de ladite mémoire est fixé à une valeur satisfaisant la condition suivante:

$$\frac{C_{FD}+C_2}{C_1+C_2+C_{FS}+C_{FD}} \geqq \alpha \geqq \frac{C_{FD}}{C_1+C_2+C_{FS}+C_{FD}}$$

$$\alpha = \frac{d_1|E_B|-0,16|V_D|}{|V_D|}$$

où $C_1$ représente la capacité existant entre le substrat semiconducteur et la grille flottante, $C_2$ représente la capacité existant entre la grille flottante et la grille de commande, $C_{FS}$ représente la capacité existant entre la région de source et la grille flottante, $C_{FD}$ représente la capacité existant entre la région de drain et la grille flottante, $d_1$ représente l'épaisseur d'au moins une partie de la couche (4) d'isolation de grille flottante, $E_B$ représente la tension pouvant déclencher la rupture par avalanche entre la région de drain et le substrat semiconducteur, et $V_D$ représente la tension appliquée au drain.

0 032 958

Fig. 1

Fig. 2

Fig. 3

$$\frac{C_2+C_{FD}}{C_1+C_2+C_{FS}+C_{FD}} \geq \alpha \geq \frac{C_{FD}}{C_1+C_2+C_{FS}+C_{FD}}$$

SUPPLY VOLTAGE, volts

1